# EUROPEAN PATENT APPLICATION

(11) **EP 4 845 033 A1**
(43) Date of publication of application: **25.11.2026**
(21) Application number: 25217713.4
(22) Date of filing: 21.11.2025
(51) Int. Cl.: H03L 7/091, H03L 7/081, H03L 7/093, H03L 7/107, H03L 7/197

(54) **STRUCTURE AND METHOD FOR SAMPLING PHASE DETECTOR WITH ADJUSTABLE GAIN**

(30) Priority: 23.05.2025 US 202519216994
(71) Applicant: GlobalFoundries U.S. Inc., Malta, NY 12020 (US)
(72) Inventor: Fridi, Ahmed R., Richardson, 75081 (US)
(74) Representative: Grünecker Patent- und Rechtsanwälte PartG mbB

(57) **Abstract**

The disclosure provides embodiments of a structure and method to provide a sampling phase detector (SPD) with an adjustable gain. A structure includes a voltage controlled oscillator (VCO) having a primary input voltage node, a secondary input voltage node, and an output clock signal node. The structure also includes a delay circuit. A sample phase detector (SPD) and a filter is connected in series between the delay circuit and the primary input voltage node. A gain of the SPD is adjustable. An amplifier is connected between the filter and the secondary input voltage node. A divider is connected between the output clock signal node and the SPD.

## Description

### BACKGROUND

The disclosure relates to signal detection and processing and, more particularly, to embodiments of a structure and method to provide a sampling phase detector (SPD) with an adjustable gain.

Sampling phase locked loops (SPLLs), whether analog or digital, are the commonly implemented for very low phase noise, low jitter applications such as wireless fidelity networking (e.g., WiFi8), serializer-deserializer (SerDes) circuits requiring data transmission over at least thirty-two gigabits per second (Gbps), or fifth generation (5G) cellular processing. A fundamental component of an SPLL is its sampling phase detector (SPD). In an SPLL, the loop bandwidth is primarily dependent on the SPD gain ("K_{SPD}") and the voltage-controlled oscillator (VCO) gain ("K_{VCO}"). A small K_{SPD}, defined by a slower voltage ramp, is desirable during the first locking phase of the PLL for providing a wider frequency/phase acquisition range. However, a large K_{SPD} is preferable in the steady state phase to set a larger loop bandwidth to suppress the transconductance gain (gm) noise without the need to increase internal capacitance, and/or the VCO gain which would increase signal noise at the VCO.

An example K_{SPD} for a 650 kilohertz (KHz) loop bandwidth is approximately 5 gigavolts per second (GV/s). In this case, the phase difference between the VCO feedback clock and the 100 Megahertz (MHz) reference clock has to be within 320 picoseconds (ps) only for 1.6 Volt (V) ramp voltage range. If not, then the VCO control voltage will rail to either supply voltage (VDD) or ground (GND) and will bring the PLL into an unknown, out-of-control state. Phase conditioning techniques to bring the phase difference of the two clocks at SPD input to a fraction of a nano-second are not practically feasible. Conventional methodology for addressing this issue is to append an additional "auxiliary PLL") to perform the locking over a much wider time window (e.g., as large as a full reference period (5-10 ns)), then turn off the auxiliary PLL when the lock is achieved. Auxiliary PLL circuitry increases manufacturing cost and operational complexity.

### SUMMARY

Aspects of the disclosure include a structure including: a voltage controlled oscillator (VCO) having a primary input voltage node, a secondary input voltage node, and an output clock signal node; a delay circuit; a sample phase detector (SPD) and a filter connected in series between the delay circuit and the primary input voltage node, wherein a gain of the SPD is adjustable; an amplifier connected between the filter and the secondary input voltage node; and a divider connected between the output clock signal node and the SPD.

Aspects of the disclosure further include a structure including: a voltage controlled oscillator (VCO) having a primary input voltage node, a secondary input voltage node, and an output clock signal node; a delay circuit configured to output a delayed clock signal; a sample phase detector (SPD) and a filter connected in series between the delay circuit and the primary input voltage node, wherein a gain of the SPD is adjustable, wherein the SPD includes: a first inverter that receives the delayed clock signal and outputs an inverted delayed clock signal; a second inverter that receives the output clock from the VCO signal and outputs an inverted output clock signal; a P-type transistor, a programmable resistor, and an N-type transistor connected in series between a positive voltage rail and ground, wherein gates of the P-type transistor and the N-type transistor are connected to receive the inverted delayed clock signal; a first switch and a second switch connected in series between a first intermediate node at a junction between the programmable resistor and the N-type transistor and an SPD output node, wherein the SPD output node is connected to the filter; a first capacitor connected between ground and a second intermediate node between the first switch and the second switch; and a second capacitor connected between ground and the SPD output node; an amplifier connected between the filter and the secondary input voltage node; and a divider connected between the output clock signal node and the SPD.

Additional aspects of the disclosure include a method including: receiving, by a sample phase detector (SPD) from a delay circuit, a delayed clock signal; outputting, by the SPD to a filter, a sample voltage; filtering, by the filter, the sample voltage to output a primary control voltage to a primary input voltage node of a voltage controlled oscillator (VCO) and to an amplifier; generating, by the amplifier based on a difference between the primary input voltage and a reference voltage, an output current, wherein the output current is output to secondary input voltage node of the VCO and wherein a secondary input voltage is generated on the second input voltage node due to the output current and an integration capacitance; generating, by the VCO based on the primary input voltage and the secondary input voltage, an output clock signal, wherein the output clock signal is output to an output clock signal node, to the SPD, and to a divider; generating, by the divider based on the output clock signal, a divided clock signal, wherein the divided clock signal is output to the SPD; and automatically adjusting, by the SPD, the sample voltage based on a phase difference between the delayed clock signal and the divided clock signal.

### BRIEF DESCRIPTION OF THE DRAWINGS

The present invention will be better understood from the following detailed description with reference to the drawings, which are not necessarily drawn to scale. In the drawings, like reference numerals refer to like features in the various views.
FIG. 1 depicts a schematic view of a structure according to embodiments of the disclosure.
FIG. 2 depicts an expanded schematic view of a sampling phase detector (SPD) with adjustable gain according to embodiments of the disclosure.
FIG. 3 depicts an example block diagram of a signal processing flow according to embodiments of the disclosure.
FIG. 4 depicts an example timing diagram of signal being processed in an SPD with adjustable gain according to embodiments of the disclosure.
FIG. 5 depicts a comparative plot of SPD acquisition range and SPD slope over time during operation according to embodiments of the disclosure.
FIG. 6 depicts an illustrative flow diagram of an operational methodology according to embodiments of the disclosure.

### DETAILED DESCRIPTION

The disclosure will now be described with reference to systems and methods for phase and frequency locked loops using sampling clock delay adjustment. While the disclosure will be described hereinafter in connection with specific devices and methods thereof, it will be understood that limiting the disclosure to such specific devices and methods is not intended. On the contrary, it is intended to cover all alternatives, modifications, and equivalents as may be included within the spirit and scope of the disclosure as defined by the appended claims.

For a general understanding of the features of the disclosure, reference is made to the drawings. The drawings are not to scale; however, in the drawings, like reference numerals have been used throughout to identify identical elements.

It will be readily understood that the devices and methods of the present disclosure, as generally described and illustrated in the drawings herein, may be arranged and designed in a wide variety of different configurations in addition to the devices and methods described herein. Thus, the following detailed description of the devices and methods, as represented in the drawings, is not intended to limit the scope defined by the appended claims but is merely representative of selected devices and methods. The following description is intended only by way of example and simply illustrates certain concepts of the devices and methods, as disclosed and claimed herein.

The disclosure provides embodiments of a structure and method to provide a sampling phase detector (SPD) with an adjustable gain. A structure includes a voltage-controlled oscillator (VCO) having a primary input voltage node, a secondary input voltage node, and an output clock signal node. The structure also includes a delay circuit. A sampling phase detector (SPD) and a filter is connected in series between the delay circuit and the primary input voltage node. The gain of the SPD is adjustable. An amplifier and, particularly, a transconductance amplifier is connected between the filter and the secondary input voltage node. A divider is connected between the output clock signal node and the SPD.

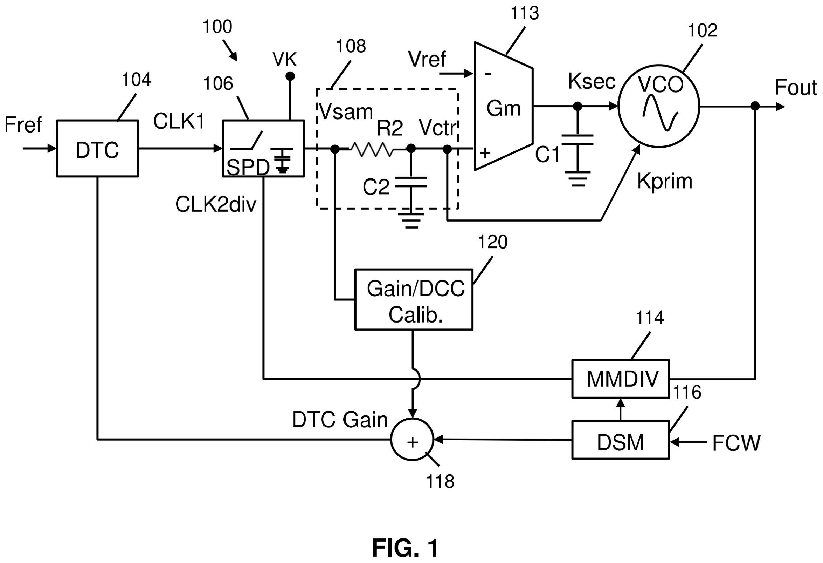

Referring to FIG. 1, an embodiment of a structure 100 according to the disclosure is shown. Structure 100 includes a voltage-controlled oscillator (VCO) 102 including a primary input voltage node (Kprim) and a secondary input voltage node (Ksec). VCO 102 also includes an output clock signal node (Fout). VCO 102 is an electrically driven oscillator configured to generate an alternating current (AC) signal having a voltage-controlled amplitude, frequency, and phase. The primary input voltage to VCO 102 at node Kprim and the secondary input voltage to VCO 102 at node Ksec, both determine the frequency of the output clock signal at node Fout. As discussed herein, apparatus 100 functions to detect the phase of an incoming sample signal and generate an output signal indicating the detected phase, via VCO 102.

Structure 100 also includes a delay circuit 104 receiving an input signal (FREF) for transmission to VCO 102 through a sample phase detector (SPD) 106. Delay circuit 104 may include any circuitry configured for adjusting the sampling start time of a signal transmitted to sampling phase detector 106, i.e., delaying its transmission without affecting other characteristics (amplitude, frequency, etc.) of the transmitted signals. In some embodiments, delay circuit 104 may include a digital-to-time converter (DTC) connected to a node for transmitting a reference clock signal (Fref). Reference clock signal Fref is delayed in delay circuit 104 (e.g., the DTC) based on a secondary input (e.g., indicating a DTC gain) which controls the amount of time delay. The amount of delay provided in delay circuit 104 may be controlled to provide a uniform time difference between reference clock Fref and samples being detected.

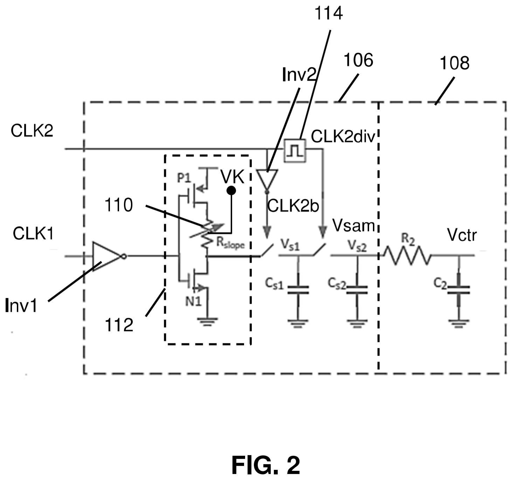

Referring to FIGS. 1 and 2 together, in which FIG. 2 provides an expanded view of SPD 106, embodiments of structure 100 include SPD 106 and a filter 108 connected in series between the delay circuit 104 and the primary input voltage node (Kprim) to VCO 102. A first clock input CLK1 provides a signal to trigger a voltage ramp within SPD 106. A second clock input CLK2 to SPD 106 samples the ramp voltage for transmission to VCO 102. SPD 106, during operation, compares signals CLK1 and CLK2 to adjust the frequency of CLK1 to align more closely with VCO 102. SPD 106 may receive CLK1 as a delayed clock signal from delay circuit 104 to output a sample voltage (Vsam) based on the second clock input CLK2. To implement this function, SPD 106 may adjust its output sample voltage (Vsam) based on a phase difference between the delayed clock signal CLK1 and a divided clock signal (CLK2) transmitted from a divider 114 (and which has been generated based on an output clock signal from VCO 102). The gain of SPD 106 controls the frequency/acquisition range, i.e., the maximum detectable time difference between CLK1 and CLK2.

As discussed herein, the loop bandwidth in structure 100 is primarily dependent on the gain (K_{SPD}) of SPD 106 and the gain of VCO 102. A small K_{SPD}, defined by a slower voltage ramp, is desirable during initial operating periods to provide a wider frequency/phase acquisition range. However, a large K_{SPD} is preferable in the steady state phase to set a larger loop bandwidth to suppress both the transconductance gain (Gm) noise without the need to increase internal capacitance, and/or the VCO gain which would increase signal noise at VCO 102. Structure 100 thus includes a gain node VK coupled to SPD 106 for adjusting K_{SPD} of SPD 106. Gain node VK may be coupled to, e.g., a programmable resistor 110 (FIG. 2 only) configured to have a variable resistance state based on a voltage applied thereto. In various implementations, programmable resistor 110 may include a digital potentiometer and/or any other currently known or later developed digitally programmable resistor configurable between two or more states of varying electrical resistance. The voltage of gain node VK may be coupled to a signal configured for adjusting the resistive state of programmable resistor 110 under varying circumstances discussed herein.

As shown specifically in FIG. 2, SPD 106 may include a first inverter Inv1 for receiving the delayed clock signal CLK1 to output an inverted delayed clock signal. SPD 106 thus also may include a second inverter Inv2 that receives the output clock signal CLK2 to output an inverted output clock signal. The output from first inverter Inv1 may be coupled to a programmable inverter 112, e.g., a complementary metal oxide semiconductor (CMOS) inverting amplifier circuit as shown. Programmable inverter 112, in the form of an inverting amplifier outputs an inverted voltage proportional to its input voltage, based on the gain of programmable inverter 112. Programmable inverter 112 may include a P-type transistor (P1), programmable resistor 110 connected in series between transistor P1 and an N-type transistor (N1). Transistors P1, N1, and programmable resistor 110 connected n series between a positive voltage rail and ground. The gates of transistors P1 and N1 may be coupled to first inverter Inv1 to receive the inverted delayed clock signal. SPD 106 in this configuration may include a first switch Vs1 and a second switch Vs2 connected in series between an intermediate node at the junction between programmable resistor 110 transistor N1, and an SPD output node defining sample voltage Vsam. Sample voltage Vsam, in turn, is connected to the input node of filter 108. SPD 106 also may include a first capacitor Cs1 coupled to ground between switches Vs1, Vs2 and a second capacitor Cs2 coupled to ground between second switch Vs2 and the output node of SPD106.

Filter 108 may function as, e.g., a lowpass filter configured to transmit only frequencies below a threshold value to subsequent portions of structure 100. According to the examples shown in FIGS. 1 and 2, filter 108 is a resistance-capacitance filter connected to receive sample voltage Vsam at its input. Resistor R2 and capacitor C2 of filter 108 may have a predetermined resistance and capacitance, respectively, to output a primary control voltage (Vctr) to primary input voltage node Kprim of VCO 102. Filter 108 includes a filter input node connected to receive sample voltage Vsam from the output of SPD 106. Filter 108, in the case of a resistor-capacitor filter, includes resistor R2 connected between the filter input node and the filter output node. Capacitor C2 is connected between the filter output node and ground. The filter output node is connected to multiple components: primary input voltage node Kprim of VCO 102 and an input to an amplifier 113 connected between filter 108 and secondary input voltage node Ksec to VCO 102.

Referring specifically to FIG. 1, amplifier 113 may include a pair of inputs configured to output a signal to secondary input voltage node Ksec proportionate to control voltage Vctr from filter 108. Amplifier 113 may be any currently known or later developed electrical amplification circuit, and in an example implementation, amplifier 113 may include a transconductance amplifier. A transconductance amplifier is an electrical circuit configured to convert an input voltage into an output current. The gain (Gm) of amplifier 113 may be derived its electrical properties (e.g., transistors therein), and the output from amplifier 113 may be dependent on a reference voltage (Vref) transmitted to amplifier 113 as a secondary input in conjunction with the gain Gm of amplifier 113. Amplifier 113, in other implementations, may include other amplifiers, circuits, and /or devices suitable for generating an output current proportional to control voltage Vctr. A capacitor C1 (also referred to herein as an integration capacitor) can be connected between secondary input voltage node Ksec and ground, e.g., to maintain a desired voltage at secondary input voltage node Ksec to VCO 102 based on output current from amplifier 113 and an integration capacitance of C1.

During operation of structure 100, VCO 102 outputs an output clock signal on an output clock signal node Fout based on the voltages to VCO 102 at input voltage nodes Kprim, Ksec. The frequency of the output clock signal VCO 102 at output clock signal node Fout is dependent on the characteristics of primary input node Kprim and secondary input node Ksec. For instance, primary input voltage node Kprim from filter 108 can define the oscillation frequency whereas secondary input voltage node Ksec (which as mentioned above is generated based on output current from amplifier 113 and the integration capacitance of C1) can provide the power supply for electrically driving VCO 102. Second clock input CLK2 to SPD 106 can be derived from the output of VCO 102, to provide a feedback loop. The second clock signal CLK2 pass from VCO 102 to SPD 106 through a divider to control whether the second switch of SPD 106 is open or closed. Divider 114 may assist with phase locked loop (PLL) functions of structure 100, e.g., by causing the frequency of second clock signal input to SPD 106 to be a predetermined divided value of the outgoing signal from VCO 102. The frequency of divided clock signal at node CLK2 may be linearly dependent on that of the output clock signal from VCO 102. In some embodiments, divider 114 may be a programmable multi-mode divider (MMDIV) circuit capable of dividing the output clock signal from VCO 102 by any one of several frequency divisors (e.g., dividing the output frequency signal by a modulus selectable between two to seven).

Structure 100, in addition to enabling active control over SPD 106 gain via node VK, enables active control of delay circuit 104. A sigma-delta modulator ("DSM" or alternatively ΣΔ) modulator (simply "modulator" hereafter) 116 may receive a frequency control word (FCW) at its input for generating digital signals indicating the frequency(ies) encoded by FCW. Modulator 116 may be included within an analog to digital converter (ADC) or may be a standalone component. Modulator 116 may be coupled to divider 114, such that FCW directly affects the divided clock frequency transmitted to SPD 106 at second clock input CLK2. Similarly, an output from modulator 116 may be coupled to a multiplier 118, which in turn has an output coupled to delay circuit 104 (e.g., DTC as discussed herein). Multiplier 118 multiplies the output of the DSM modulator 116 with another signal encoding a DTC Gain value. Multiplier 118 and outputs a DTC code that selects the delayed Fref (CK1) in the DTC 104.

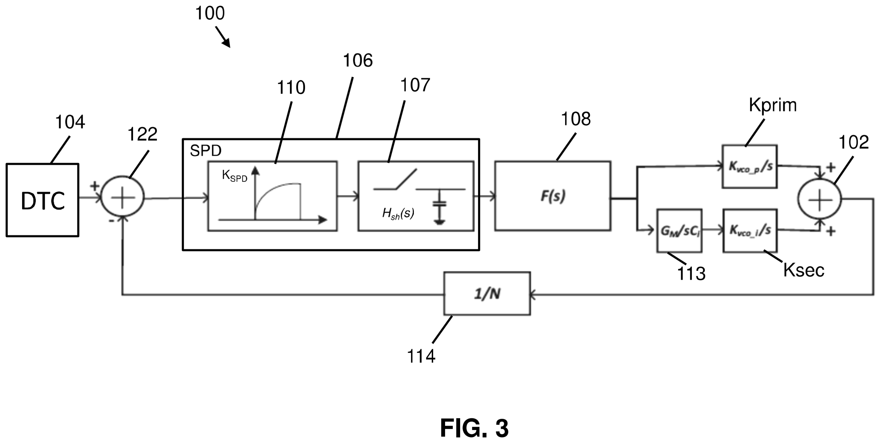

FIG. 3 provides a linear s-domain block diagram representation of structure 100 to further illustrate signal processing flows from DTC 104 to VCO 102. The open loop gain transfer function is ${G}_{OL} \left(s\right) = {K}_{SPD} {H}_{SH} \left(s\right) F \left(s\right) \left(\frac{Gm}{{sC}_{i}}\frac{{K}_{vco _ i}}{s}+\frac{{K}_{vco _ p}}{s}\right)$. In this equation, SPD 106 is represented by a constant gain K_{SPD} followed by a sample and hold 107 whose transfer function is Hₛₕ(s). The SPD 106 is followed by a filter F(s) 108 whose filtering function is described by $\left(s\right) = \frac{{R}_{2} {C}_{2} s}{1 + {R}_{2} {C}_{2} s}$. The output from filter 108 then travels along two parallel signal paths. In one path, the output from filter 108 is applied to primary input voltage node Kprim to VCO 102. Along the other pathway, the signal is amplified in amplifier 113 (e.g., a transconductance amplifier as discussed elsewhere herein) and transmitted to secondary input voltage node Ksec to VCO 102. VCO 102 in turn can transmit its output to divider 114 to be compared against incoming delayed clock signals from delay circuit 104 to provide a negative feedback loop. The unity gain frequency (also known as the loop bandwidth) is mainly set by the SPD gain K_{SPD} and the VCO gain Kprim and is insensitive to Gm and Ksec. The feed forward path provides a zero at (*K_{vco_i}*/ *K_{vco_p}*)*.*(*Gm*/ (2*π Cᵢ*))*.*

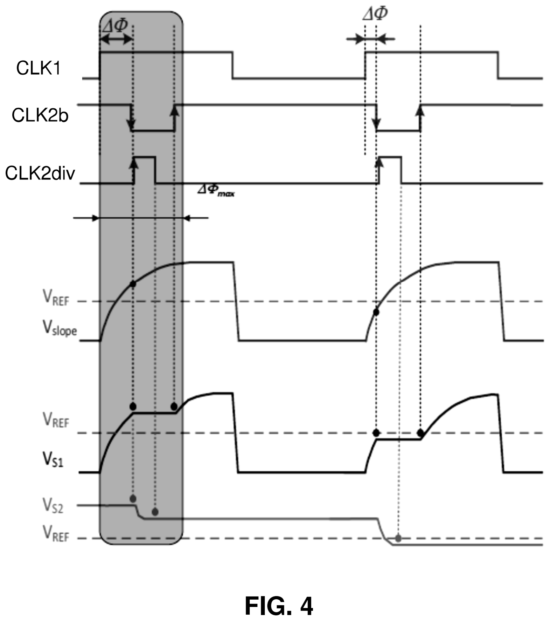

Referring to FIGS. 1, 2, and 4 together, in which FIG. 4 provides a timing diagram of signals transmitted through SPD 106 during operation, further features of structure 100 are discussed. The timing diagram of FIG. 4 in particular illustrates how programmable inverter 112 and programmable resistor 110 may control the gain K_{SPD} of SPD 106 to improve signal processing through structure 100 during transient and steady state operating phases. The timing diagram indicates three clock waveforms: CLK1 to indicate the delayed clock signal to SPD 106; CLK2b to indicate the inverted output clock signal from VCO 102; and CLK 2div to indicate the divided clock signal from divider 114. Three additional plots in FIG. 4 compare the fixed reference voltage (VREF) to structure 100 with different voltage levels: Vslope to indicate the voltage at the output of SPD 106; VS1 to indicate the voltage at the junction between the first switch and the second switch and further coupled to capacitor Cs1; and VS2 to indicate the voltage at the junction between the second switch and the filter 108 and further coupled to capacitor CS2 and filter 108. According to the transfer function indicated by the block diagram in FIG. 3, the gain of SPD 106 is directly proportional to the voltage difference across programmable inverter 112, and thus, increasing or decreasing the resistance of programmable resistor 110 linearly increases or decreases the gain K_{SPD} across SPD 106.

Variable ΔΦ indicates the phase difference between clock signals CLK2b, CLK2div. Relative to time, the first set of clock signals indicate transient operation of structure 100 and the latter set of clock signals indicate steady state operation. The greyscale box within the timing diagram indicates the maximum detectable phase difference between clock signals CLK2b, CLK2div. As shown, the phase difference ΔΦ between clock signals CLKb, CLKdiv is larger during transient operation than during steady state operation. Thus, a larger detection window for SPD 106 is required during transient operation than during steady state operation. Programmable resistor 110 and programmable inverter 112 enable the timing window to be manipulated (e.g., lengthened or shortened) without including or relying on an auxiliary PLL. By controlling programmable resistor 110 and/or programmable inverter 112 thereof, an operator of structure 100 can prevent structure 100 from entering an uncontrollable and/or unstable state that might otherwise occur when the phase difference ΔΦ is larger than the detection window. In addition, due to the direct coupling between filter 108 output and primary input voltage node Kprim to VCO 102, the gain of amplifier 113 has substantially no effect on the gain K_{SPD} of SPD 106.

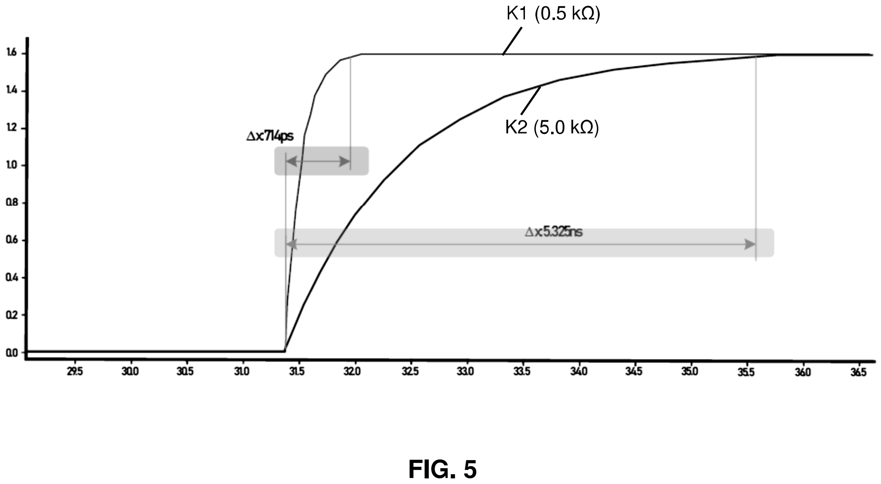

Referring now to FIGS. 1, 4, and 5 together, structure 100 enables an operator to selectively expand or contract the maximum phase difference that SPD 106 can detect to suit varying operational situations. FIG. 5 in particular illustrates a comparative plot of SPD 106 maximum phase difference versus SPD slope (i.e., voltage difference from input to output) By increasing the voltage across programmable resistor 110, the detection window for SPD 106 can expand or retract relative to time. Regardless of whether structure 100 is in a transient or steady state operating condition, the phase difference between signals CLK2b, CLK2div being less than a predetermined maximum phase difference (i.e., structure 100 is operating at its steady state), sample voltage Vsam is within an operating range for the PLL functions of structure 100 and SPD 106 remains at a first gain level. When the phase difference between signals CLK2b, CLK2div is above the predetermined maximum phase difference, structure 100 may be in a transient operating state. In this case, the gain of the SPD automatically switches to a second, higher gain level via programmable resistor 110 to expand the phase detection window. In FIG. 5, curve K1 indicates the gain of SPD 106 when programmable inverter 112 is set to a first, lower value (e.g., 0.5 kilohm (kΩ)) and curve K2 indicates the gain of SPD 106 when programmable inverter 112 is set to a second, higher value (e.g., 5.0 kΩ). The higher gain for higher resistance curve K2 provides a longer detection window, e.g., approximately 5.325 nanoseconds (ns) compared to the approximately 714 picosecond (ps) detection window for lower resistance curve K1. The shorter detection window for curve K1 may be preferable for steady state operation, e.g., to prevent multiple pairs of clock inputs CLK2b, CLK2div being erroneously detected together.

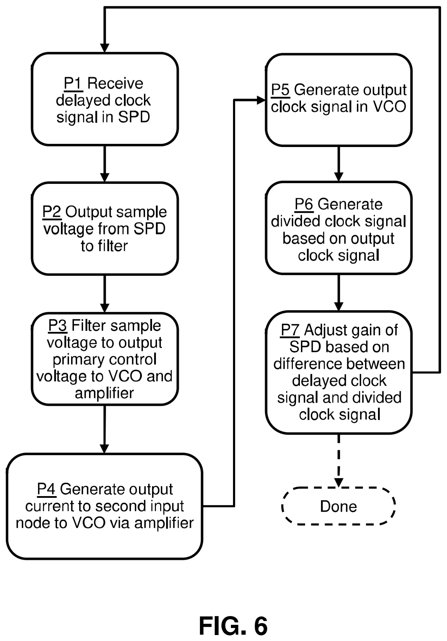

Turning to FIGS. 1, 2, and 6 together, in which FIG. 6 provides an example flow diagram of processes P1-P7, methods of the disclosure are discussed. Methods according to the disclosure may include operating structure 100 with varying amounts of gain K_{SPD} across SPD 106 to accommodate transient or steady state operating conditions. In process P1, SPD 106 receives a delayed clock signal originating from delay circuit 104. Thereafter, SPD 106 outputs a sample voltage to filter 108 in process P2. SPD 106 and filter 108 are connected in series between delay circuit 102 and primary input voltage node Kprim to VCO 102. As discussed herein, SPD 106 has an adjustable gain K_{SPD}. The gain of SPD 106 is adjustable by applying a voltage to node KD to adjust the gain across programmable resistor 110 and/or programmable inverter 112.

In process P3, filter 108 outputs control voltage Vctr. The control voltage provides a corresponding output current transmitted to primary input node Kprim to VCO 102. Simultaneously, the control voltage is also transmitted to amplifier 113. In process P5, amplifier 113 generates a separate output current for transmission to secondary input voltage node Ksec to VCO 102. Amplifier 113, as discussed herein, may be a transconductance amplifier configured to output an output current based on an input voltage thereto, and the gain Gm of amplifier 113 may not be dependent on any properties of SPD 106. Processes P3, P4 thereby apply two input currents to input nodes Kprim, Ksec of VCO 102, in which the input to primary input voltage node Kprim has not passed through amplifier 113 whereas the input to secondary node Ksec is amplified in amplifier 113 before reaching VCO 102.

Process P5 may include generating an output clock from VCO 102 based on the currents at each input voltage node (Kprim, Ksec) from filter 108 and amplifier 113, respectively. VCO 102 thus produces an output clock signal that, in process P6, may be converted to a lower frequency in divider 114 to create divided clock signal CLK2div. In process P5, VCO 102 also transmits its output clock signal to SPD 106, e.g., to second inverter Inv2 thereof. SPD 106 operates by continuously comparing signals CLK2b and CLK2div from VCO 102 to adjust the frequency of CLK1 to align more closely with the output signal from VCO 102.

In process P7, the gain K_{SPD} of SP 106 may be adjusted, e.g., by applying different voltage levels to SPD 106 at gain node VK. The adjusting in process P7 may be based on whether VCO 102 is undergoing transient or steady state operation, e.g., the detection window for SPD 106 may be expanded or reduced to accommodate larger or smaller timing differences between its incoming clock signals CLK2b, CLK2div. The adjusting in process P7, in addition, may be automatic based on a detected phase difference between the inverted output clock signal (CLK2b) and the divided clock signal (CLK2) provided to SPD 106. The method may repeat after adjusting the gain of SPD 106 in process P7 or alternatively may conclude ("Done") after the gain of SPD 106 is set to a desired level.

Embodiments of the disclosure provide various technical and commercial advantages, examples of which are discussed herein. Structure 100 and related methods provided herein can selectively increase phase detection window of SPD 106 solely by adjusting the gain of programmable inverter 112. The adjusting of programmable inverter 112, e.g., using programmable inverter 110, can change the slope of SPD gain K_{SPD} via internal circuitry of SPD 106. These features, among other benefits, avoid the need for an interconnected auxiliary PLL to be used together with SPD 106 and its interconnected components. Embodiments of structure 100, moreover, incur no significant penalties to area or power consumption in device hardware.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

References herein to terms modified by language of approximation, such as "about," "approximately," and "substantially," are not to be limited to the precise value specified. The language of approximation may correspond to the precision of an instrument used to measure the value and, unless otherwise dependent on the precision of the instrument, may indicate +/-10% of the stated value(s).

References herein to terms such as "vertical," "horizontal," etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction perpendicular to the horizontal, as just defined. The term "lateral" refers to a direction within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or "in direct contact with" another feature if intervening features are absent. A feature may be "indirectly on" or "in indirect contact with" another feature if at least one intervening feature is present.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the disclosure provides embodiments of a structure and method to provide a sampling phase detector (SPD) with an adjustable gain. A structure includes a voltage controlled oscillator (VCO) having a primary input voltage node, a secondary input voltage node, and an output clock signal node. The structure also includes a delay circuit. A sample phase detector (SPD) and a filter is connected in series between the delay circuit and the primary input voltage node. A gain of the SPD is adjustable. An amplifier is connected between the filter and the secondary input voltage node. A divider is connected between the output clock signal node and the SPD.
The following embodiments are explicitly disclosed.
Embodiment 1: A structure comprising:
   a voltage controlled oscillator (VCO) having a primary input voltage node, a secondary input voltage node, and an output clock signal node;
   a delay circuit;
   a sample phase detector (SPD) and a filter connected in series between the delay circuit and the primary input voltage node, wherein a gain of the SPD is adjustable;
   an amplifier connected between the filter and the secondary input voltage node; and
   a divider connected between the output clock signal node and the SPD.
   In some illustrative examples herein, the SPD may be further connected to receive the output clock signal.
Embodiment 2: The structure of embodiment 1, wherein the delay circuit includes a digital-to-time converter (DTC) connected to receive a reference clock signal, wherein, based on the reference clock signal and a DTC gain value, the DTC outputs a delayed clock signal to the SPD.
Embodiment 3: The structure of embodiment 1 or 2, further comprising a capacitor connected between the secondary input voltage node and ground.
Embodiment 4: The structure of one of embodiments 1 to 3,
   wherein the SPD is connected to receive a delayed clock signal from the delay circuit,
   wherein the SPD outputs a sample voltage based on the delayed clock signal;
   wherein the filter is connected to receive the sample voltage and, based on the sample voltage, outputs a primary control voltage to the primary input voltage node of the VCO,
   wherein, based on the primary control voltage at the primary input voltage node and a secondary control voltage at the secondary input voltage node, the VCO outputs an output clock signal on the output clock signal node, and
   wherein the divider is connected to receive the output clock signal and, based on the output clock signal, outputs a divided clock signal to the SPD.
Embodiment 5: The structure of embodiment 4, wherein the SPD adjusts the sample voltage based on a phase difference between the delayed clock signal and the divided clock signal.
Embodiment 6: The structure of embodiment 5,
   wherein, when the phase difference is less than a predetermined maximum phase difference, the sample voltage is within an operating range for a phase locked loop and the gain of the SPD is at a first gain level, and
   wherein, when the phase difference is above the predetermined maximum phase difference, the gain of the SPD is automatically switched to a second gain level.
Embodiment 7: The structure of embodiment 4 or 5, wherein the SPD is further connected to receive the output clock signal.
Embodiment 8: The structure of one of embodiments 4 to 7, wherein the SPD includes:
   a first inverter that receives the delayed clock signal and outputs an inverted delayed clock signal;
   a second inverter that receives the output clock signal and outputs an inverted output clock signal;
   a P-type transistor, a programmable resistor, and an N-type transistor connected in series between a positive voltage rail and ground, wherein gates of the P-type transistor and the N-type transistor are connected to receive the inverted delayed clock signal;
   a first switch and a second switch connected in series between a first intermediate node at a junction between the programmable resistor and the N-type transistor and an SPD output node, wherein the SPD output node is connected to the filter;
   a first capacitor connected between ground and a second intermediate node between the first switch and the second switch; and
   a second capacitor connected between ground and the SPD output node.
Embodiment 9: The structure of embodiment 8, wherein the gain of the SPD is adjustable by switching a resistance state of the programmable resistor.
Embodiment 10: The structure of one of embodiments 1 to 9, wherein the filter is a resistance-capacitance filter including:
   a filter input node connected to receive the sample voltage from an SPD output node;
   a filter output node connected to the amplifier and the VCO;
   a resistor connected between the filter input node and the filter output node; and
   a capacitor connected between the filter output node and ground.
Embodiment 11: The structure of one of embodiments 1 to 10, wherein the amplifier includes a transconductance amplifier.
Embodiment 12: The structure of one of embodiments 1 to 11, wherein the divider includes a programmable multi-mode divider.
Embodiment 13: A structure comprising:
   a voltage controlled oscillator (VCO) having a primary input voltage node, a secondary input voltage node, and an output clock signal node;
   a delay circuit configured to output a delayed clock signal;
   a sample phase detector (SPD) and a filter connected in series between the delay circuit and the primary input voltage node, wherein a gain of the SPD is adjustable, wherein the SPD includes:
      a first inverter that receives the delayed clock signal and outputs an inverted delayed clock signal;
      a second inverter that receives the output clock from the VCO signal and outputs an inverted output clock signal;
      a P-type transistor, a programmable resistor, and an N-type transistor connected in series between a positive voltage rail and ground, wherein gates of the P-type transistor and the N-type transistor are connected to receive the inverted delayed clock signal;
      a first switch and a second switch connected in series between a first intermediate node at a junction between the programmable resistor and the N-type transistor and an SPD output node, wherein the SPD output node is connected to the filter;
      a first capacitor connected between ground and a second intermediate node between the first switch and the second switch; and
      a second capacitor connected between ground and the SPD output node;
   a transconductance amplifier connected between the filter and the secondary input voltage node; and
   a divider connected between the output clock signal node and the SPD.
Embodiment 14: The structure of embodiment 13, wherein the delay circuit includes a digital-to-time converter (DTC) connected to receive a reference clock signal, wherein, based on the reference clock signal and a DTC gain value, the DTC outputs the delayed clock signal to the SPD.
Embodiment 15: The structure of embodiment 13 or 14, wherein the SPD is further connected to receive the output clock signal.
Embodiment 16: The structure of one of embodiments 13 to 15, wherein the SPD adjusts the sample voltage based on a phase difference between the delayed clock signal and the divided clock signal.
Embodiment 17: The structure of one of embodiments 13 to 16, wherein the divider includes a programmable multi-mode divider.
Embodiment 18: A method comprising:
   receiving, by a sample phase detector (SPD) from a delay circuit, a delayed clock signal;
   outputting, by the SPD to a filter, a sample voltage;
   filtering, by the filter, the sample voltage to output a primary control voltage to a primary input voltage node of a voltage controlled oscillator (VCO) and to an amplifier;
   generating, by the amplifier based on a difference between the primary input voltage and a reference voltage, an output current, wherein the output current is output to secondary input voltage node of the VCO and wherein a secondary input voltage is generated on the second input voltage node due to the output current and an integration capacitance;
   generating, by the VCO based on the primary input voltage and the secondary input voltage, an output clock signal, wherein the output clock signal is output to an output clock signal node, to the SPD, and to a divider;
   generating, by the divider based on the output clock signal, a divided clock signal, wherein the divided clock signal is output to the SPD; and
   automatically adjusting, by the SPD, the sample voltage based on a phase difference between the delayed clock signal and the divided clock signal.
   In some illustrative examples herein, the method of embodiment 18 may further comprise operating the structure of one of embodiments 1 to 17.
Embodiment 19: The method of embodiment 18, wherein the amplifier includes a transconductance amplifier.
Embodiment 20: The method of embodiment 18 or 19, wherein the divider includes a programmable multi-mode divider.
Embodiment 21: A structure comprising:
   a voltage controlled oscillator (VCO) having a primary input voltage node, a secondary input voltage node, and an output clock signal node;
   a delay circuit;
   a sample phase detector (SPD) and a filter connected in series between the delay circuit and the primary input voltage node, wherein a gain of the SPD is adjustable;
   an amplifier connected between the filter and the secondary input voltage node; and
   a divider connected between the output clock signal node and the SPD.
   In some illustrative examples herein, the SPD may be configured to adjust the sample voltage based on a phase difference between the delayed clock signal and the divided clock signal.
   In some other illustrative examples herein, the SPD may be further connected to receive the output clock signal
Embodiment 22: The structure of embodiment 21, wherein the delay circuit includes a digital-to-time converter (DTC) connected to receive a reference clock signal, wherein, based on the reference clock signal and a DTC gain value, the DTC outputs a delayed clock signal to the SPD, and/or
   wherein the structure further comprises a capacitor connected between the secondary input voltage node and ground.
Embodiment 23: The structure of embodiment 21 or 22, wherein the filter is a resistance-capacitance filter including:
   a filter input node connected to receive the sample voltage from an SPD output node;
   a filter output node connected to the amplifier and the VCO;
   a resistor connected between the filter input node and the filter output node; and
   a capacitor connected between the filter output node and ground, and/or wherein the amplifier includes a transconductance amplifier, and/or wherein the divider includes a programmable multi-mode divider.
Embodiment 24: The structure of one of embodiments 21 to 23,
   wherein the SPD is connected to receive a delayed clock signal from the delay circuit,
   wherein the SPD outputs a sample voltage based on the delayed clock signal;
   wherein the filter is connected to receive the sample voltage and, based on the sample voltage, outputs a primary control voltage to the primary input voltage node of the VCO,
   wherein, based on the primary control voltage at the primary input voltage node and a secondary control voltage at the secondary input voltage node, the VCO outputs an output clock signal on the output clock signal node, and
   wherein the divider is connected to receive the output clock signal and, based on the output clock signal, outputs a divided clock signal to the SPD.
Embodiment 25: The structure of embodiment 24, wherein the SPD adjusts the sample voltage based on a phase difference between the delayed clock signal and the divided clock signal.
Embodiment 26: The structure of embodiment 25,
   wherein, when the phase difference is less than a predetermined maximum phase difference, the sample voltage is within an operating range for a phase locked loop and the gain of the SPD is at a first gain level, and
   wherein, when the phase difference is above the predetermined maximum phase difference, the gain of the SPD is automatically switched to a second gain level.
Embodiment 27: The structure of one of embodiments 24 to 26, wherein the SPD is further connected to receive the output clock signal.
Embodiment 28: The structure of one of embodiments 24 to 27, wherein the SPD includes:
   a first inverter that receives the delayed clock signal and outputs an inverted delayed clock signal;
   a second inverter that receives the output clock signal and outputs an inverted output clock signal;
   a P-type transistor, a programmable resistor, and an N-type transistor connected in series between a positive voltage rail and ground, wherein gates of the P-type transistor and the N-type transistor are connected to receive the inverted delayed clock signal;
   a first switch and a second switch connected in series between a first intermediate node at a junction between the programmable resistor and the N-type transistor and an SPD output node, wherein the SPD output node is connected to the filter;
   a first capacitor connected between ground and a second intermediate node between the first switch and the second switch; and
   a second capacitor connected between ground and the SPD output node, wherein the gain of the SPD preferably is adjustable by switching a resistance state of the programmable resistor.
Embodiment 29: The structure of one of embodiments 21 to 27, wherein the delay circuit is configured to output a delayed clock signal;
   wherein the amplifier comprises a transconductance amplifier; and wherein the SPD includes:
   a first inverter that receives the delayed clock signal and outputs an inverted delayed clock signal;
   a second inverter that receives the output clock from the VCO signal and outputs an inverted output clock signal;
   a P-type transistor, a programmable resistor, and an N-type transistor connected in series between a positive voltage rail and ground, wherein gates of the P-type transistor and the N-type transistor are connected to receive the inverted delayed clock signal;
   a first switch and a second switch connected in series between a first intermediate node at a junction between the programmable resistor and the N-type transistor and an SPD output node, wherein the SPD output node is connected to the filter;
   a first capacitor connected between ground and a second intermediate node between the first switch and the second switch; and
   a second capacitor connected between ground and the SPD output node.
Embodiment 30: The structure of embodiment 29, wherein the SPD is further connected to receive the output clock signal.
Embodiment 31: The structure of embodiment 29 or 30, wherein the SPD adjusts the sample voltage based on a phase difference between the delayed clock signal and the divided clock signal.
Embodiment 32: A method comprising:
   receiving, by a sample phase detector (SPD) from a delay circuit, a delayed clock signal;
   outputting, by the SPD to a filter, a sample voltage;
   filtering, by the filter, the sample voltage to output a primary control voltage to a primary input voltage node of a voltage controlled oscillator (VCO) and to an amplifier;
   generating, by the amplifier based on a difference between the primary input voltage and a reference voltage, an output current, wherein the output current is output to secondary input voltage node of the VCO and wherein a secondary input voltage is generated on the second input voltage node due to the output current and an integration capacitance;
   generating, by the VCO based on the primary input voltage and the secondary input voltage, an output clock signal, wherein the output clock signal is output to an output clock signal node, to the SPD, and to a divider;
   generating, by the divider based on the output clock signal, a divided clock signal, wherein the divided clock signal is output to the SPD; and
   automatically adjusting, by the SPD, the sample voltage based on a phase difference between the delayed clock signal and the divided clock signal.
   In some illustrative examples herein, the method may further comprise operating the structure of one of embodiments 21 to 31.
Embodiment 33: The method of embodiment 32, wherein the amplifier includes a transconductance amplifier.
Embodiment 34: The method of embodiment 32 or 33, wherein the divider includes a programmable multi-mode divider.
Embodiment 35: The method of one of embodiments 32 to 34, wherein the structure of one of embodiments 21 to 31 is operated.

## Claims

1. A structure comprising:
a voltage controlled oscillator (VCO) having a primary input voltage node, a secondary input voltage node, and an output clock signal node;
a delay circuit;
a sample phase detector (SPD) and a filter connected in series between the delay circuit and the primary input voltage node, wherein a gain of the SPD is adjustable;
an amplifier connected between the filter and the secondary input voltage node; and
a divider connected between the output clock signal node and the SPD.

2. The structure of claim 1, wherein the delay circuit includes a digital-to-time converter (DTC) connected to receive a reference clock signal, wherein, based on the reference clock signal and a DTC gain value, the DTC outputs a delayed clock signal to the SPD, and/or
wherein the structure further comprises a capacitor connected between the secondary input voltage node and ground.

3. The structure of claim 1 or 2, wherein the filter is a resistance-capacitance filter including:
a filter input node connected to receive the sample voltage from an SPD output node;
a filter output node connected to the amplifier and the VCO;
a resistor connected between the filter input node and the filter output node; and
a capacitor connected between the filter output node and ground, and/or wherein the amplifier includes a transconductance amplifier, and/or wherein the divider includes a programmable multi-mode divider.

4. The structure of one of claims 1 to 3,
wherein the SPD is connected to receive a delayed clock signal from the delay circuit,
wherein the SPD outputs a sample voltage based on the delayed clock signal;
wherein the filter is connected to receive the sample voltage and, based on the sample voltage, outputs a primary control voltage to the primary input voltage node of the VCO,
wherein, based on the primary control voltage at the primary input voltage node and a secondary control voltage at the secondary input voltage node, the VCO outputs an output clock signal on the output clock signal node, and
wherein the divider is connected to receive the output clock signal and, based on the output clock signal, outputs a divided clock signal to the SPD.

5. The structure of claim 4, wherein the SPD adjusts the sample voltage based on a phase difference between the delayed clock signal and the divided clock signal.

6. The structure of claim 5,
wherein, when the phase difference is less than a predetermined maximum phase difference, the sample voltage is within an operating range for a phase locked loop and the gain of the SPD is at a first gain level, and
wherein, when the phase difference is above the predetermined maximum phase difference, the gain of the SPD is automatically switched to a second gain level.

7. The structure of one of claims 4 to 6, wherein the SPD is further connected to receive the output clock signal.

8. The structure of one of claims 4 to 7, wherein the SPD includes:
a first inverter that receives the delayed clock signal and outputs an inverted delayed clock signal;
a second inverter that receives the output clock signal and outputs an inverted output clock signal;
a P-type transistor, a programmable resistor, and an N-type transistor connected in series between a positive voltage rail and ground, wherein gates of the P-type transistor and the N-type transistor are connected to receive the inverted delayed clock signal;
a first switch and a second switch connected in series between a first intermediate node at a junction between the programmable resistor and the N-type transistor and an SPD output node, wherein the SPD output node is connected to the filter;
a first capacitor connected between ground and a second intermediate node between the first switch and the second switch; and
a second capacitor connected between ground and the SPD output node,
wherein the gain of the SPD preferably is adjustable by switching a resistance state of the programmable resistor.

9. The structure of one of claims 1 to 7, wherein the delay circuit is configured to output a delayed clock signal;
wherein the amplifier comprises a transconductance amplifier; and
wherein the SPD includes:
a first inverter that receives the delayed clock signal and outputs an inverted delayed clock signal;
a second inverter that receives the output clock from the VCO signal and outputs an inverted output clock signal;
a P-type transistor, a programmable resistor, and an N-type transistor connected in series between a positive voltage rail and ground, wherein gates of the P-type transistor and the N-type transistor are connected to receive the inverted delayed clock signal;
a first switch and a second switch connected in series between a first intermediate node at a junction between the programmable resistor and the N-type transistor and an SPD output node, wherein the SPD output node is connected to the filter;
a first capacitor connected between ground and a second intermediate node between the first switch and the second switch; and
a second capacitor connected between ground and the SPD output node.

10. The structure of claim 9, wherein the SPD is further connected to receive the output clock signal.

11. The structure of claim 9 or 10, wherein the SPD adjusts the sample voltage based on a phase difference between the delayed clock signal and the divided clock signal.

12. A method comprising:
receiving, by a sample phase detector (SPD) from a delay circuit, a delayed clock signal;
outputting, by the SPD to a filter, a sample voltage;
filtering, by the filter, the sample voltage to output a primary control voltage to a primary input voltage node of a voltage controlled oscillator (VCO) and to an amplifier;
generating, by the amplifier based on a difference between the primary input voltage and a reference voltage, an output current, wherein the output current is output to secondary input voltage node of the VCO and wherein a secondary input voltage is generated on the second input voltage node due to the output current and an integration capacitance;
generating, by the VCO based on the primary input voltage and the secondary input voltage, an output clock signal, wherein the output clock signal is output to an output clock signal node, to the SPD, and to a divider;
generating, by the divider based on the output clock signal, a divided clock signal, wherein the divided clock signal is output to the SPD; and
automatically adjusting, by the SPD, the sample voltage based on a phase difference between the delayed clock signal and the divided clock signal.

13. The method of claim 12, wherein the amplifier includes a transconductance amplifier.

14. The method of claim 12 or 13, wherein the divider includes a programmable multi-mode divider.

15. The method of one of claims 12 to 14, wherein the structure of one of claims 1o to 11 is operated.
